# EUROPÄISCHE PATENTSCHRIFT

(11) **EP 1 943 706 B1**
(45) Veröffentlichungstag und Bekanntmachung des Hinweises auf die Patenterteilung: **18.03.2015**
(21) Anmeldenummer: 05804390.2
(22) Anmeldetag: 27.10.2005
(51) Int. Cl.: H01S 5/022, H01S 5/024, G02B 6/42

(54) **HALBLEITERLASERVORRICHTUNG**
SEMICONDUCTOR LASER DEVICE
DISPOSITIF LASER SEMI-CONDUCTEUR

(43) Veröffentlichungstag der Anmeldung: 16.07.2008
(73) Patentinhaber: LIMO Patentverwaltung GmbH & Co. KG, 44319 Dortmund (DE)
(72) Erfinder: STÖHR, Detlef, Dipl.-Ing, 44575 Castrop-Rauxel (DE); BARTOSCHEWSKI, Daniel, 45883 Gelsenkirchen (DE)
(74) Vertreter: Basfeld, Rainer
(86) Internationale Anmeldenummer: PCT/DE2005/001928
(87) Internationale Veröffentlichungsnummer: WO 2007/048362

(56) Entgegenhaltungen:
- EP-A- 1 519 208
- US-A- 5 727 104
- US-A- 5 793 792
- US-A1- 2002 018 627
- US-A1- 2004 114 884
- US-A1- 2004 114 884
- US-B1- 6 227 724

## Beschreibung

Die vorliegende Erfindung betrifft eine Halbleiterlaservorrichtung gemäß dem Oberbegriff des Anspruchs 1.

Aus der US 2004/0114884 A1 ist eine Halbleiterlaservorrichtung der eingangs genannten Art bekannt. Die darin beschriebene Halbleiterlaservorrichtung umfasst ein Gehäuse, das aus einem einteiligen Unterteil und einem zweiteiligen Oberteil besteht. Als Unterteil dient eine Wärmesenke, die einen mittigen erhöhten Sockel und einen diesen Sockel umgebende, zu der Sockeloberfläche parallele Fläche aufweist, die ein um den Sockel umlaufendes Dichtmittel trägt. Dabei dient die Oberseite des Sockels als Anlagefläche für ein Halbleiterlaserelement. Die mit dem Dichtmittel versehene umlaufende Fläche dient als Anlagefläche für das Oberteil des Gehäuses.

Aus der US 5,793,792 ist eine weitere Halbleiterlaservorrichtung bekannt. Die darin beschriebene Halbleiterlaservorrichtung umfasst eine Wärmesenke, die eine horizontale Fläche für die Montage des Halbleiterlaserelements und eine vor dieser angeordnete Montagefläche für eine Kollimationsoptik aufweist. Die Montagefläche erstreckt sich dabei unter einem Winkel von etwa 45° von der horizontalen Fläche nach unten, um die sich von dem Halbleiterlaserelement divergent ausbreitende Laserstrahlung nicht zu beeinträchtigen.

Das der vorliegenden Erfindung zugrunde liegende Problem ist die Schaffung einer Halbleiterlaservorrichtung der eingangs genannten Art, die weniger Raum benötigt.

Dies wird erfindungsgemäß durch eine Halbleiterlaservorrichtung der eingangs genannten Art mit den kennzeichnenden Merkmalen des Anspruchs 1 erreicht.

Gemäß Anspruch 1 ist vorgesehen, dass die erste Anlagefläche und die zweite Anlagefläche einen Winkel zwischen 3° und 15° einschließen. Beispielsweise kann dabei der Winkel zwischen erster und zweiter Anlagefläche zwischen 5° und 10°, insbesondere etwa 8° betragen. Der Winkel zwischen der für die Anlage des Halbleiterlaserelementes dienenden ersten Anlagefläche und der für die Anlage des Oberteiles dienenden zweiten Anlagefläche bewirkt, dass die erste Anlagefläche an einer ihrer Seiten einen größeren Abstand zu der zweiten Anlagefläche in Richtung der Flächennormalen der ersten Anlagefläche aufweist als an der zu dieser einen Seite gegenüberliegenden Seite. Die Seite mit dem größeren Abstand wird in der Regel die Seite sein, an der das Halbleiterlaserelement auf der ersten Anlagefläche angebracht ist. Durch den Winkel zwischen erster und zweiter Anlagefläche ergibt sich somit insbesondere vor dem Halbleiterlaserelement eine Stufe oder Aussparung, die Raum für die Montage beispielsweise von der Halbleiterlaservorrichtung umfasster Optikmittel lässt. Diese Optikmittel können der Beeinflussung der aus dem mindestens einen Halbleiterlaserelement austretenden Laserstrahlung dienen. Derartige Optikmittel können beispielsweise als Fast-Axis-Kollimationslinse ausgebildet sein.

Dabei kann sich die zweite Anlagefläche im Wesentlichen in einer Ebene erstrecken.

Weiterhin besteht die Möglichkeit, dass das Gehäuseoberteil und die als Gehäuseunterteil dienende Wärmesenke im Wesentlichen in einer Ebene aneinander und/oder an den Dichtmitteln anliegen.

Es kann vorgesehen sein, dass die Dichtmittel die erste Anlagefläche umgeben, insbesondere im Wesentlichen in der Ebene der zweiten Anlagefläche.

Es kann beispielsweise vorgesehen sein, dass die Dichtmittel derart gestaltet sind, dass die dichte Verbindung zwischen Gehäuseoberteil und Gehäuseunterteil eine Leckrate kleiner als 2·10⁻⁶ mbar·l·s⁻¹ beziehungsweise kleiner als 2·10⁻⁷ N·m·s⁻¹, insbesondere eine Leckrate kleiner als 1·10⁻⁶ mbar·l·s⁻¹ beziehungsweise kleiner als 1·10⁻⁷ N·m·s⁻¹ gewährleistet. Es zeigt sich also, dass mit den Dichtmitteln eine vergleichsweise kleine Leckrate realisierbar ist.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen
- Fig. 1: eine Explosionsdarstellung einer erfindungsgemäßen Halbleiterlaservorrichtung;
- Fig. 2: eine perspektivische Ansicht der Halbleiterlaservorrichtung gemäß Fig. 1;
- Fig. 3: eine perspektivische Ansicht der Wärmesenke mit einem Halbleiterlaserelement der Halbleiterlaservorrichtung gemäß Fig. 1;
- Fig. 4: einen Schnitt gemäß den Pfeilen IV-IV in Fig. 6;
- Fig. 5: einen Schnitt gemäß den Pfeilen V-V in Fig. 6;
- Fig. 6: eine Draufsicht auf die Halbleiterlaservorrichtung gemäß Fig. 1;
- Fig. 7: eine Draufsicht auf die Wärmesenke mit Halbleiterlaservorrichtung gemäß Fig. 3;
- Fig. 8: eine Ansicht gemäß dem Pfeil VIII in Fig. 7;
- Fig. 9: eine Ansicht gemäß dem Pfeil IX in Fig. 7.

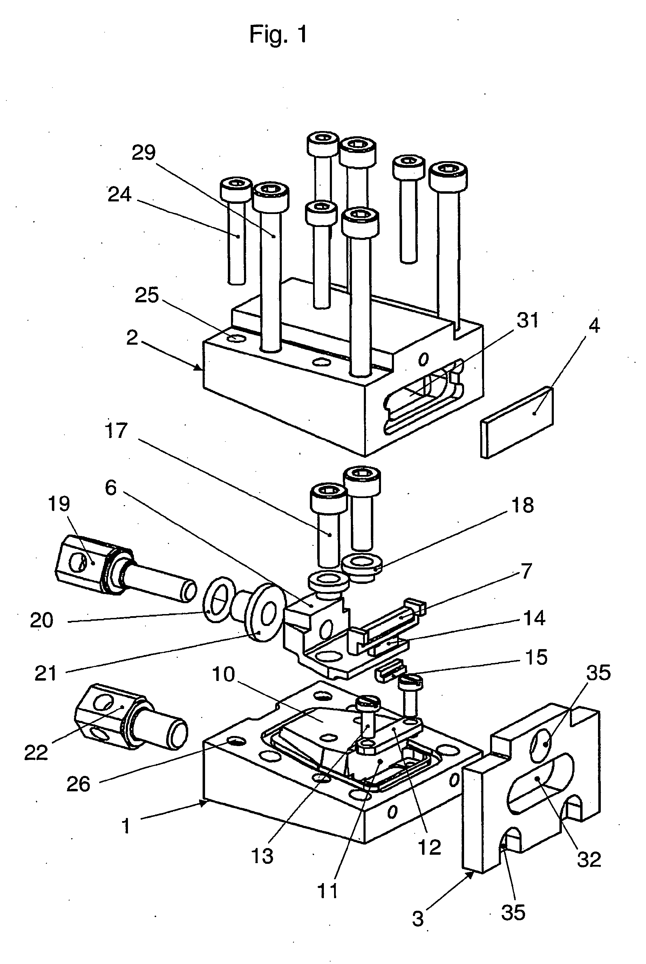

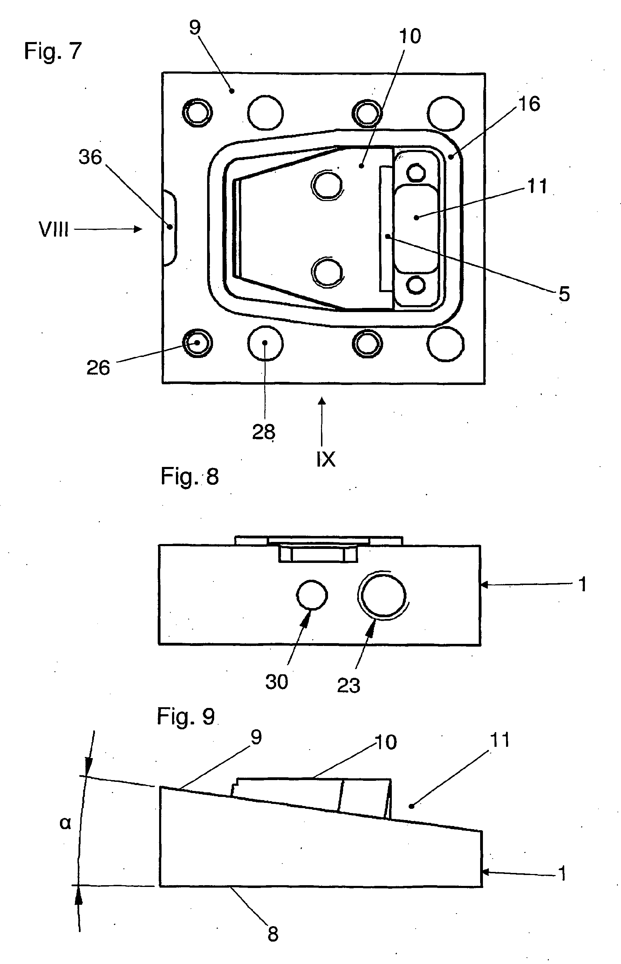

Aus Fig. 1 ist ersichtlich, dass eine erfindungsgemäße Halbleiterlaservorrichtung eine als Gehäuseunterteil dienende Wärmesenke 1 und ein Gehäuseoberteil 2 umfasst, die miteinander verbunden werden können. Weiterhin umfasst die Halbleiterlaservorrichtung eine Gehäusefrontplatte 3, die insbesondere ein Austrittsfenster 4 haltern kann. Alternativ kann das Austrittsfenster 4 direkt in das Gehäuseoberteil 2 integriert sein. Zusätzlich umfasst die abgebildete Halbleiterlaservorrichtung ein beispielsweise als Laserdiodenbarren ausgeführtes Halbleiterlaserelement 5 (siehe dazu beispielsweise Fig. 7) sowie Montagemittel für eine Kathode 6 und Optikmittel, die insbesondere als Fast-Axis-Kollimationslinse 7 ausgebildet sind.

Die Wärmesenke 1 weist eine im Wesentlichen quadratische Grundfläche 8 sowie eine zu dieser beabstandete zweite Anlagefläche 9 auf. Die zweite Anlagefläche 9 und die Grundfläche 8 schließen, wie dies insbesondere aus Fig. 9 ersichtlich ist, einen Winkel α von beispielsweise etwa 8° miteinander ein. In der Seitenansicht gemäß Fig. 9 fällt somit die zweite Anlagefläche 9 von links nach rechts etwas ab, so dass die Wärmesenke 1 in der Seitenansicht etwa keilförmig ausgebildet ist. Die Wärmesenke 1 stellt also im Wesentlichen einen schräg abgeschnittenen Quader dar.

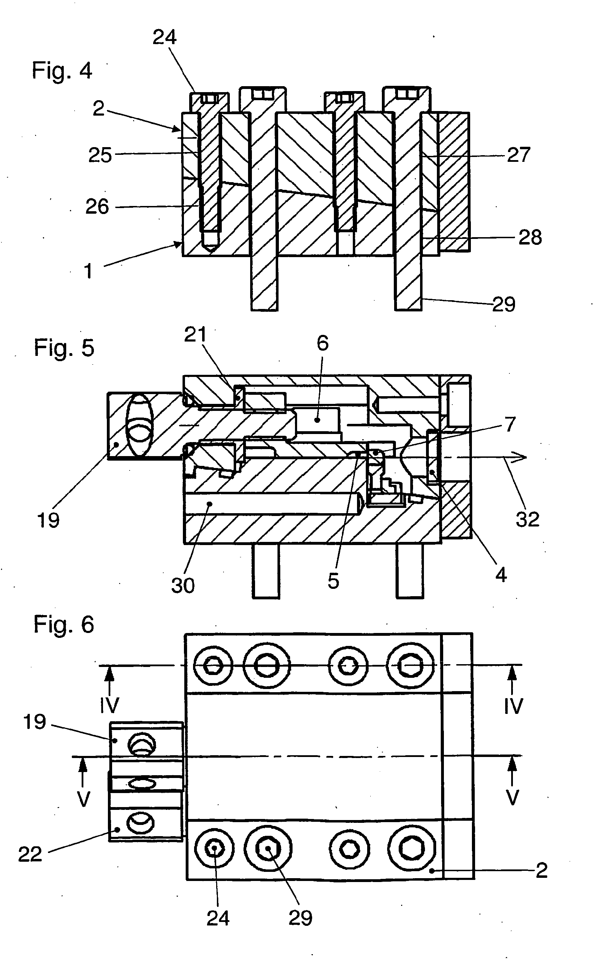

Aus Fig. 4 ist ersichtlich, dass nicht nur die Wärmesenke 1 sondern auch das Gehäuseoberteil 2 einen schräg abgeschnittenen Quader darstellt. Bei der Wärmesenke 1 ist die Oberseite schräg abgeschnitten wohingegen bei dem Gehäuseoberteil 2 die Unterseite schräg abgeschnitten ist.

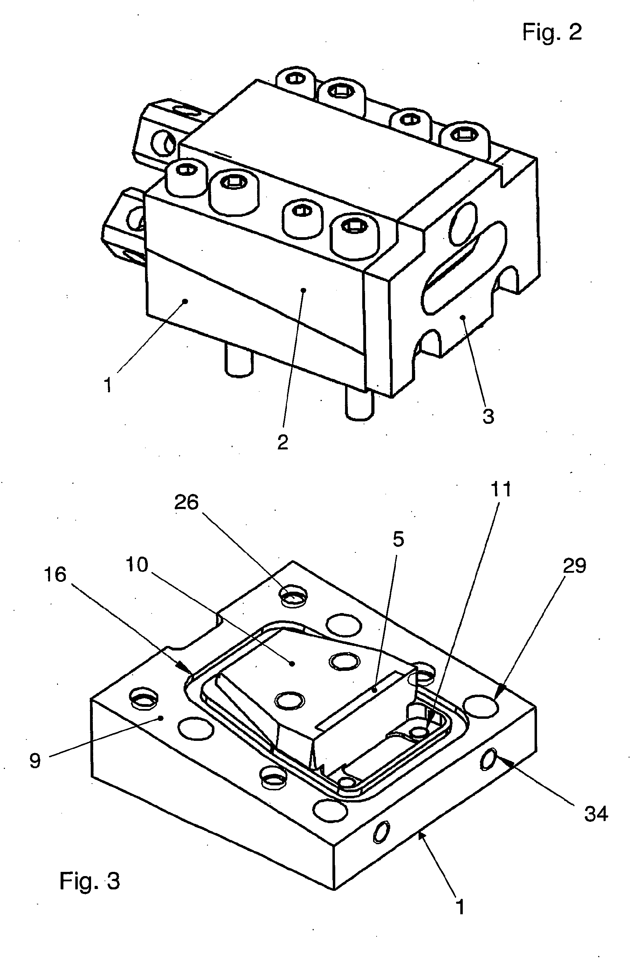

Die zweite Anlagefläche 9 bildet nicht die gesamte Oberfläche der Wärmesenke 1. Vielmehr ist in dem mittleren Bereich der Oberseite der Wärmesenke 1 eine erste Anlagefläche 10 vorgesehen, die der Anlage des Halbleiterlaserelementes 5 dient. Insbesondere aus Fig. 3 und Fig. 7 ist ersichtlich, dass das Halbleiterlaserelement in einem Endbereich, nämlich in dem in Fig. 7 rechten Endbereich der ersten Anlagefläche 10 aufgebracht ist.

Die erste Anlagefläche 10 ist, wie dies insbesondere aus Fig. 9 ersichtlich ist, parallel zu der Grundfläche 8 der Wärmesenke 1. Aus diesem Grunde schließt auch die erste Anlagefläche 10 mit der zweiten Anlagefläche 9 den vorgenannten Winkel α ein. Aufgrund des Winkels zwischen der ersten Anlagefläche 10 und der zweiten Anlagefläche 9 ergibt sich auf der in Fig. 9 rechten Seite der ersten Anlagefläche 9 ein deutlich größerer vertikaler Abstand zwischen der ersten und der zweiten Anlagefläche 9, 10 als auf der in Fig. 9 linken Seite der ersten Anlagefläche 10. Weiterhin erstreckt sich die erste Anlagefläche 10 auf der in Fig. 9 rechten Seite nicht bis zu der zweiten Anlagefläche 9. Vielmehr ist zwischen diesen beiden ein Abstand, der einen sich horizontal und vertikal erstreckenden Montageraum 11 ermöglicht. Dieser Montageraum 11 ist beispielsweise aus Fig. 3, Fig. 7 und Fig. 9 ersichtlich.

Der Montageraum 11 kann zur Aufnahme der vorgenannten Montagemittel dienen. Die Montagemittel können ein Blech 12 umfassen, das vermittels Schrauben 13 im Bereich der Unterseite des Montageraums 11 mit der Wärmesenke 1 verbunden werden kann (siehe dazu Fig. 1). Auf das Blech 12 kann ein Linsenhalter 14 aufgesetzt werden, der die Fast-Axis-Kollimationslinsen 7 haltert. Der Linsenhälter 14 und das Blech 12 können über einen Winkel 15 beispielsweise durch Kleben, Löten oder Hartlöten miteinander verbunden werden.

Aus Fig. 3 und Fig. 7 ist ersichtlich, dass um die erste Anlagefläche 10 herum in der zweiten Anlagefläche 9 eine Nut 16 für die Aufnahme eines nicht abgebildeten O-Rings vorgesehen ist. Der nicht abgebildete O-Ring umgibt somit die erste Anlagefläche 10 und den Montageraum 11 lückenlos und kann an der als dritte Anlagefläche dienenden Unterseite des Gehäuseoberteils 2 abdichtend anliegen.

Aus Fig. 1 ist weiterhin die Kathode 6 ersichtlich, die vermittels Schrauben 17 und Isolierbuchsen 18 mit der ersten Anlagefläche 10 verbunden werden kann. Dabei kontaktiert ein Teil der Unterseite der Kathode 6 die Oberseite des Halbleiterlaserelementes 5. Insbesondere ist zwischen der nicht auf der Oberseite des Halbleiterlaserelementes 5 aufliegenden Unterseite der Kathode 6 und der Oberseite der Anlagefläche 10 eine nicht leitende Schicht oder ein nicht leitendes Material vorgesehen.

Die Kathode 6 kann von der Außenseite durch das Gehäuseoberteil 2 mit einem Elektroanschluss 19 verbunden werden. Dieser Elektroanschluss 19 wird über einen O-Ring 20 und eine Isolierbuchse 21 gegenüber dem Gehäuseoberteil 2 isoliert (siehe dazu Fig. 1 und Fig. 5).

Weiterhin kann die als Anode dienende Oberseite der ersten Anlagefläche 10, mit der die Unterseite des Halbleiterlaserelements 5 elektrisch leitend verbunden ist, durch einen Elektroanschluss 22 kontaktiert werden. Dieser wird beispielsweise einfach in eine Gewindebohrung 23 der Wärmesenke 1 eingeschraubt (siehe dazu Fig. 8).

Das Gehäuseoberteil 2 und die Wärmesenke 1 sind durch Schrauben 24 miteinander verbunden, diese Schrauben 24 können beispielsweise durch Bohrungen 25 hindurchragen und in entsprechende Gewindebohrungen 26 der Wärmesenke 1 eingeschraubt werden. Weiterhin können sowohl in dem Gehäuseoberteil 2 als auch in der als Gehäuseunterteil dienenden Wärmsenke 1 durchgehende Bohrungen 27, 28 für Schrauben 29 vorgesehen sein, die beispielsweise die gesamte Halbleiterlaservorrichtung an einer Apparatur festschrauben können (siehe dazu beispielsweise Fig. 1, Fig. 4 und Fig. 7).

Aus Fig. 5 und Fig. 8 ist weiterhin eine Bohrung 30 in der Wärmesenke 1 erkennbar, die als Aufnahme für Sensormittel dient.

Aus Fig. 1 ist weiterhin ersichtlich, dass das Gehäuseoberteil 2 eine Öffnung 31 für den Hindurchtritt der von dem Halbleiterlaserelement 5 ausgehenden Laserstrahlung 32 aufweist (siehe dazu auch Fig. 5). In die Öffnung 31 kann das Fenster 4 eingebracht werden. Weiterhin weist auch die Gehäusefrontplatte 3 eine Öffnung 33 für den Hindurchtritt der Laserstrahlung 32 auf.

Die Gehäusefrontplatte 3 kann durch nicht abgebildete Schrauben mit der Wärmesenke 1 verbunden werden. Insbesondere können dafür entsprechende Gewindebohrungen 34 an der Vorderseite der Wärmesenke 1 und/oder des Gehäuseoberteils 2 vorgesehen sein. Diese Schrauben können durch entsprechende Öffnungen oder Bohrungen 35 der Frontplatte 3 hindurchragen.

An der in Fig. 7 linken Seite der Wärmesenke 1 ist in der zweiten Anlagefläche 9 eine Haltenut 36 vorgesehen, die für den Eingriff von Befestigungsmitteln dienen kann. Insbesondere dient diese Haltenut 36 als entsprechende Aufnahme für eine am Gehäuseoberteil 2 angeordnete Nase. Der Eingriff der Nase in die Haltenut 36 verhindert das Abrutschen des Gehäuseoberteils 2 beim Verschrauben auf der Wärmesenke 1.

Die Wärmesenke 1 kann vollständig oder zumindest abschnittsweise aus einem keramischen Material bestehen. Insbesondere kann ein keramisches Material verwendet werden, dem Kohlenstoff-Nano-Röhrchen beigemischt sind. Eine derartige Keramik kann dadurch hergestellt werden, dass dem als Ausgangsmaterial für die Herstellung der Keramik dienenden Pulver Kohlenstoff-Nano-Röhrchen beigemischt werden.

Eine derartige Keramik kann eine sehr hohe thermische und elektrische Leitfähigkeit aufweisen. Weiterhin kann sie auch aufgrund der Kohlenstoff-Nano-Röhrchen sehr bruchfest sein. Insbesondere erweist es sich als vorteilhaft, wenn der thermische Ausdehnungskoeffizient einer derartigen aus Keramik hergestellten Wärmesenke 1 dem des Halbleiterlaserelementes 5, und insbesondere dem von Galliumarsenid entspricht. Auf diese Weise besteht die Möglichkeit, das Halbleiterlaserelement 5 durch Hartlöten mit der Wärmesenke 1 beziehungsweise der ersten Anlagefläche 10 der Wärmesenke 1 zu verbinden.

## Patentansprüche

1. Halbleiterlaservorrichtung, umfassend
- mindestens ein Halbleiterlaserelement (5);
- ein Gehäuseoberteil (2) und ein Gehäuseunterteil, die im miteinander verbundenen Zustand das Halbleiterlaserelement (5) zumindest teilweise umgeben ;
- Dichtmittel für die dichte Verbindung von Gehäuseoberteil (2) und Gehäuseunterteil;
- eine als Gehäuseunterteil dienende Wärmesenke (1) mit einer ersten Anlagefläche (10), an der das mindestens eine Halbleiterlaserelement (5) anliegt, und mit einer zweiten Anlagefläche (9) für die Dichtmittel und/oder für eine mit den Dichtmitteln zusammenwirkende dritte Anlagefläche des Gehäuseoberteils (2);
**dadurch gekennzeichnet, dass** die erste Anlagefläche (10) und die zweite Anlagefläche (9) einen Winkel (α) zwischen 3° und 15° einschließen.

2. Halbleiterlaservorrichtung nach Anspruch 1, **dadurch gekennzeichnet, dass** die zweite Anlagefläche (9) sich im Wesentlichen in einer Ebene erstreckt.

3. Halbleiterlaservorrichtung nach einem der Ansprüche 1 oder 2, **dadurch gekennzeichnet, dass** das Gehäuseoberteil (2) und die als Gehäuseunterteil dienende Wärmesenke (1) im Wesentlichen in einer Ebene aneinander und/oder an den Dichtmitteln anliegen.

4. Halbleiterlaservorrichtung nach einem der Ansprüche 1 bis 3, **dadurch gekennzeichnet, dass** der Winkel (α) zwischen erster und zweiter Anlagefläche (9, 10) zwischen 5° und 10°, insbesondere etwa 8° beträgt.

5. Halbleiterlaservorrichtung nach einem der Ansprüche 1 bis 4, **dadurch gekennzeichnet, dass** die Dichtmittel die erste Anlagefläche (10) umgeben, insbesondere im Wesentlichen in der Ebene der zweiten Anlagefläche (9).

6. Halbleiterlaservorrichtung nach einem der Ansprüche 1 bis 5, **dadurch gekennzeichnet, dass** die Halbleiterlaservorrichtung Optikmittel für die Beeinflussung der aus dem mindestens einen Halbleiterlaserelement (5) austretenden Laserstrahlung (32) umfasst.

7. Halbleiterlaservorrichtung nach Anspruch 6, **dadurch gekennzeichnet, dass** die Optikmittel mindestens eine Fast-Axis-Kollimationslinse (7) umfassen.

8. Halbleiterlaservorrichtung nach einem der Ansprüche 6 oder 7, **dadurch gekennzeichnet, dass** die Halbleiterlaservorrichtung Montagemittel für die Montage der Optikmittel umfasst.

9. Halbleiterlaservorrichtung nach einem der Ansprüche 6 bis 8, **dadurch gekennzeichnet, dass** zwischen der ersten Anlagefläche (10) und der zweiten Anlagefläche (9) zumindest in einem Bereich, der benachbart zu dem Halbleiterlaserelement (5) ist, ein derartigen Zwischenraum gebildet wird, dass dieser Zwischenraum Platz für die Montage der Optikmittel bietet.

10. Halbleiterlaservorrichtung nach einem der Ansprüche 1 bis 9, **dadurch gekennzeichnet, dass** die Dichtmittel derart gestaltet sind, dass die dichte Verbindung zwischen Gehäuseoberteil (2) und Gehäuseunterteil eine Leckrate kleiner als 2·10⁻⁶ mbar·l·s⁻¹ beziehungsweise kleiner als 2·10⁻⁷ N·m·s⁻¹, insbesondere eine Leckrate kleiner als 1·10⁻⁶ mbar·l·s⁻¹ beziehungsweise kleiner als 1·10⁻⁷ N·m·s⁻¹ gewährleistet.

## Claims

1. Semiconductor laser device, comprising
- at least one semiconductor laser element (5);
- a housing upper part (2) and a housing lower part, which in the interconnected state, at least partly surround the semiconductor laser element (5);
- sealing means for the tight connection of housing upper part (2) and housing lower part;
- a heat sink (1) serving as housing lower part having a first bearing area (10), on which the at least one semiconductor laser element (5) bears, and having a second bearing area (9) for the sealing means and/or for a third bearing area of the housing upper part (2), said third bearing area interacting with the sealing means;
**characterized in that** the first bearing area (10) and the second bearing area (9) form an angle (α) of between 3° and 15°.

2. Semiconductor laser device according to Claim 1, **characterized in that** the second bearing area (9) extends substantially in one plane.

3. Semiconductor laser device according to any of Claims 1 and 2, **characterized in that** the housing upper part (2) and the heat sink (1) serving as housing lower part bear on one another and/or on the sealing means substantially in one plane.

4. Semiconductor laser device according to any of Claims 1 to 3, **characterized in that** the angle (α) between the first and second bearing areas (9, 10) is between 5° and 10°, in particularly approximately 8°.

5. Semiconductor laser device according to any of Claims 1 to 4, **characterized in that** the sealing means surround the first bearing area (10), in particular substantially in the plane of the second bearing area (9).

6. Semiconductor laser device according to any of Claims 1 to 5, **characterized in that** the semiconductor laser device comprises optical means for influencing the laser radiation (32) emerging from the at least one semiconductor laser element (5).

7. Semiconductor laser device according to Claim 6, **characterized in that** the optical means comprise at least one fast-axis collimation lens (7).

8. Semiconductor laser device according to either of Claims 6 and 7, **characterized in that** the semiconductor laser device comprises mounting means for the mounting of the optical means.

9. Semiconductor laser device according to any of Claims 6 to 8, **characterized in that** between the first bearing area (10) and the second bearing area (9) at least in a region which is adjacent to the semiconductor laser element (5), an interspace is formed such that said interspace affords space for the mounting of the optical means.

10. Semiconductor laser device according to any of Claims 1 to 9, **characterized in that** the sealing means are configured in such a way that the tight connection between housing upper part (2) and housing lower part ensures a leakage rate of less than 2·10⁻⁶ mbar·l·s⁻¹ or less than 2·10⁻⁷ N·m·s⁻¹, in particular a leakage rate of less than 1·10⁻¹, mbar·l·s⁻¹ or less than 1·10⁻⁷ N·m·s⁻¹.

## Revendications

1. Dispositif à laser à semi-conducteur comprenant :
- au moins un élément de laser à semi-conducteur (5) ;
- une partie supérieure de boîtier (2) et une partie inférieure de boîtier, qui entourent au moins partiellement l'élément de laser à semi-conducteur (5) lorsqu'ils sont dans l'état connectés l'un à l'autre ;
- des moyens d'étanchéité pour le raccordement étanche de la partie supérieure de boîtier (2) et de la partie inférieure de boîtier ;
- un puits thermique (1) jouant le rôle de partie inférieure de boîtier comportant une première surface de support (10) sur laquelle repose l'au moins un élément de laser à semi-conducteur (5), et comportant une deuxième surface de support (9) destinée aux moyens d'étanchéité et/ou à une troisième surface de support de la partie supérieure de boîtier (2) coopérant avec les moyens d'étanchéité ;
**caractérisé en ce que** la première surface de support (10) et la deuxième surface de support (9) délimitent un angle (α) compris entre 3° et 15°.

2. Dispositif à laser à semi-conducteur selon la revendication 1, **caractérisé en ce que** la deuxième surface de support (9) s'étend sensiblement dans un plan.

3. Dispositif à laser à semi-conducteur selon l'une quelconque des revendications 1 ou 2, **caractérisé en ce que** la partie supérieure de boîtier (2) et le puits thermique (1) jouant le rôle de partie inférieure de boîtier se situent sensiblement l'un contre l'autre ou contre les moyens d'étanchéité dans un plan.

4. Dispositif à laser à semi-conducteur selon l'une quelconque des revendications 1 à 3, **caractérisé en ce que** l'angle (α) entre les première et deuxième surfaces de support (9, 10) est compris entre 5° et 10° et est notamment d'environ 8°.

5. Dispositif à laser à semi-conducteur selon l'une quelconque des revendications 1 à 4, caractérisé en ce les moyens d'étanchéité entourent la première surface de support (10), notamment sensiblement dans le plan de la deuxième surface de support (9).

6. Dispositif à laser à semi-conducteur selon l'une quelconque des revendications 1 à 5, **caractérisé en ce que** le dispositif à laser à semi-conducteur comprend des moyens optiques destinés à agir sur le rayonnement laser (32) émanant de l'au moins un élément de laser à semi-conducteur (5).

7. Dispositif à laser à semi-conducteur selon la revendication 6, **caractérisé en ce que** les moyens optiques comprennent au moins une lentille de collimation d'axe rapide (7).

8. Dispositif à laser à semi-conducteur selon l'une quelconque des revendications 6 ou 7, **caractérisé en ce que** le dispositif à laser à semi-conducteur comprend des moyens de montage pour le montage des moyens optiques.

9. Dispositif à laser à semi-conducteur selon l'une quelconque des revendications 6 à 8, **caractérisé en ce que**, entre la première surface de support (10) et la deuxième surface de support (9), dans au moins une zone voisine de l'élément de laser à semi-conducteur (5), un espace intermédiaire est formé de manière à ce que ledit espace intermédiaire fournisse un espace pour le montage des moyens optiques.

10. Dispositif à laser à semi-conducteur selon l'une quelconque des revendications 1 à 9, **caractérisé en ce que** les moyens d'étanchéité sont conçus de manière à ce que le raccordement étanche entre la partie supérieure de boîtier (2) et la partie inférieure de boîtier garantisse un débit de fuite inférieur à 2·10⁻⁶ mbar·l·s⁻¹, ou inférieur à 2·10⁻⁷ N·m·s⁻¹, et plus particulièrement, un débit de fuite inférieur à 1·10⁻⁶ mbar·1·s⁻¹, ou inférieur à 1·10⁻⁷ N·m·s⁻¹.
